# EUROPEAN PATENT SPECIFICATION

(11) **EP 3 491 101 B1**
(45) Date of publication and mention of the grant of the patent: **25.11.2020**
(21) Application number: 17748704.8
(22) Date of filing: 27.07.2017
(51) Int. Cl.: C09K 11/02, C09K 11/88

(54) **A PHOTOSENSITIVE COMPOSITION, COLOR CONVERTING MEDIUM, OPTICAL DEVICES AND METHOD FOR PRODUCING SAME**
LICHTEMPFINDLICHE ZUSAMMENSETZUNG, FARBUMWANDLUNGSMEDIUM, OPTISCHE VORRICHTUNGEN UND VERFAHREN ZUR HERSTELLUNG DAVON
COMPOSITION PHOTOSENSIBLE, SUPPORT DE CONVERSION DE COULEURS, DISPOSITIFS OPTIQUES ET PROCÉDÉ DE PRÉPARATION ASSOCIÉ

(30) Priority: 01.08.2016 EP 16182225
(43) Date of publication of application: 05.06.2019
(73) Proprietor: Merck Patent GmbH, 64293 Darmstadt (DE)
(72) Inventor: HIRAYAMA, Yuki, Tokyo 194-0213 (JP); KISHIMOTO, Tadashi, Sagamihara-Shi Kanagawa 252-0143 (JP); SUZUKI, Masayoshi, Tokyo 151-0062 (JP); YOKOYAMA, Daishi, Kakegawa-City 436-0046 (JP); TANIGUCHI, Katsuto, Iwata-shi Shizuoka-Pref. 438-0832 (JP); SUZUKI, Teruaki, Sagamihara-shi Kanagawa 252-0301 (JP)
(86) International application number: PCT/EP2017/068972
(87) International publication number: WO 2018/024592

(56) References cited:
- WO-A1-2016/035602
- WO-A1-2016/134820
- US-A1- 2016 215 212

## Description

### Field of the invention

The present invention relates to a photosensitive composition, and a color conversion medium. The present invention further relates to a use of the photosensitive compostion in a color conversion medium fabrication process, and to a use of the color conversion medium in an optical device. The invention furhtermore relates to an optical device and method for preparing the color conversion medium and the optical device.

### Background Art

A photo sensitive composition comprising a nanosized fluorescent material and polymer, color conversion medium including a fluorescent material, and an optical device including a light conversion medium are used in a variety of optical applications especially for optical devices.

For example, as described in JP 2014-174406 A, WO 2014/129067 A1, WO 2012/059931A1, JP 3820633 B, EP 01403355 A, JP 2014-10398 A, EP 02056158 A, WO 2010/143461 A1.

Furthermore, WO2016/134820 A1 discloses a photosensitive composition comprising a nanosized fluorescent material, wetting and dispersing additive, polysiloxane and a (meth)acrylic polymer, and a fabrication process for a color conversion film and a method for preparing an optical device using the photosensitive composition.

US2016/215212 A1 discloses a photosensitive resin composition comprising CdSe/ZnS quantum dots, dipentaerythritolhexacrylate, photopolymerization initiator alkali soluble resin prepared in preparation example 2 of D2 and disperbyk^{(™)}-180.

WO2016/035602 A1 discloses a curable composition comprising quantum dots, Irgacure^{(™)} 907, DPHA and Disperbyk^{(™)}-180 and a solvent.

### Patent Literature

1. JP 2014-174406 A
2. WO 2014/129067 A1
3. WO 2012/059931 A1
4. JP 3820633 B
5. JP 2014-10398 A
6. EP 01403355 A
7. EP 02056158 A
8. WO 2010/143461 A1
9. WO2016/134820 A1
10. US2016/215212 A1
11. WO2016/035602 A1

### Non Patent Literature

None

### Summary of the invention

However, the inventors newly have found that there is still one or more of considerable problems for which improvement is desired, as listed below.
1. A novel photosensitive compostion comprising a plurality of nanosized fluorescent materials, and a (meth)acrylic polymer, which may lead better dispersivity of nanosized fluorescent materials in a color convesion medium, preferably in a color conversion film, with higher concentration of the nanosized fluorescent materials, is requested.
2. A novel photosensitive compostion comprising a nanosized fluorescent materials, and a (meth)acrylic polymer, which can realize improved dispersivity of nanosized fluorescent materials in a composition with higher concentration of the nanosized fluorescent materials, is desired.
3. A novel photosensitive composition comprising a plurality of nanosized fluorescent materials, and a (meth)acrylic polymer, which can form thiner film with good uniformity and good dispersivity of a plurality of nanosized fluorescent materials in the film when it is used for film fabrication process, is required.
4. A novel photosensitive compostion comprising a plurality of nanosized fluorescent materials, and a (meth)acrylic polymer which well fits to lower temprerature method for preparation of color conversion medium to save energy in the preparaton and / or to prevent quenching of the plurality of nanosized fluorescent materials in the preparation of color conversion medium, is desired.

The inventors aimed to solve one or more of the aforementioned problems 1 to 4, preferably to solve all the problems at the same time.

Surprisingly, the inventors have found a novel photosensitive composition comprising, essentially consisting, or consisting of, a plurality of nanosized fluorescent materials, a (meth)acrylic polymer, and a wetting and dispersing agent, wherein the wetting and dispersing agent comprises an anchoring group which forms a salt of cationic species and anionic species wherein the cationic species of the anchoring group is selected from the group consisting of primary ammonium, secondary ammonium, tertiary ammonium, quaternary ammonium, and a combination of any of these, wherein the (meth)acrylic polymer further comprises a silane modified (meth)acrylic unit, and
said photosensitive composition does not include polysiloxane, solves one or more of the problems 1 to 4, preferably solves all the problems 1 to 4 at the same time.

In another aspect, the invention relates to a color conversion medium (100) comprising, essentially consisting, or consisting of, a plurality of nanosized fluorescent materials (110), a (meth)acrylic polymer (120), and a wetting and dispersing agent, wherein the wetting and dispersing agent comprises an anchoring group which forms a salt of cationic species and anionic species wherein the cationic species of the anchoring group is selected from the group consisting of primary ammonium, secondary ammonium, tertiary ammonium, quaternary ammonium, and a combination of any of these, wherein the (meth)acrylic polymer further comprises a silane modified (meth)acrylic unit, and
said photosensitive composition does not include polysiloxane.

In another aspect, the invention further relates to use of the photosensitive composition in a color conversion medium fabrication process.

In another aspect, the invention also relates to an optical device (200) comprising the color conversion medium (100).

In another aspect, the invention furthermore relates to method for preparing the color conversion medium, wherein the method comprises following steps (a) and (b) in this sequence;
(a) providing the photosensitive composition onto a substrate, and
(b) polymerizing the photosensitive composition by heat treatment, or exposing the photosensitive composition under ray of light or a combination of any of these.

In another aspect, the invention also relates to method for preparing the optical device (200), wherein the method comprises following step (A); providing the color conversion medium (100), in an optical device.

### Description of drawings

Fiq.1: shows a cross sectional view of a schematic of one embodiment of a color conversion medium (100).
Fig.2: shows a cross sectional view of a shematic of another embodiment of a color conversion medium of the invention (100)
Fig. 3: shows a cross sectional view of a schematic of one embodiment of an optical device of the invention (200).
Fig. 4: shows a cross sectional view of a schematic of another embodiment of an optical device of the invention (200).

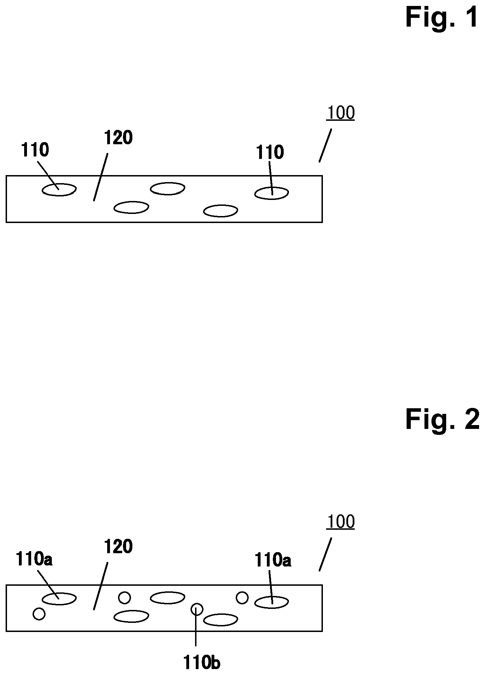

### List of reference signs in figure 1

100. a color conversion medium (for example a color conversion film)
110. a nanosized fluorescent material
120. a polymer matrix

### List of reference signs in figure 2

100. a color conversion medium (for example a color conversion film)
110a. a nanosized fluorescent material (such as quantum rod)
110b. another type of nanosized fluorescent material (such as quantum dot)
120. a polymer matrix

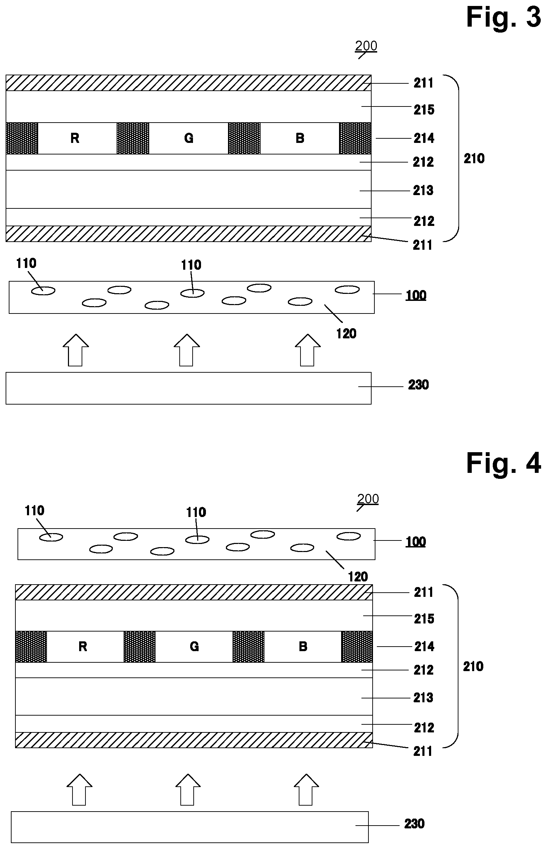

### List of reference signs in figure 3

200. an optical device
100. a color conversion medium (such as a color conversion film)
110. a nanosized fluorescent material
120. a polymer matrix
210. a light modulator
211. a polarizer
212. an electrode
213. a liquid crystal layer
214. a color filter
215. a substrate
230. a light source

### List of reference signs in figure 4

200. an optical device
100. a color conversion medium (such as a color conversion film)
110. a nanosized fluorescent material
120. a polymer matrix
210. a light modulator
211. a polarizer
212. an electrode
213. a liquid crystal layer
214. a color filter
215. a substrate
230. a light source

### Detailed Description of the invention

1. According to the present invention, a photosensitive composition comprising, essentially consisting, or consisting of, a plurality of nanosized fluorescent materials, a (met)acrylic polymer, and a wetting and dispersing agent, wherein the wetting and dispersing agent comprises an anchoring group which forms a salt of cationic species and anionic species wherein the cationic species of the anchoring group is selected from the group consisting of primary ammonium, secondary ammonium, tertiary ammonium, quaternary ammonium, and a combination of any of these, wherein the (meth)acrylic polymer further comprises a silane modified (meth)acrylic unit, and said photosensitive composition does not include polysiloxane, solves the problems 1 - 4 mentioned above at the same time.

### - Wetting and Dispersing agents

According to the present invention, the photosensitive composition comprises a wetting and dispersing agent, in which the wetting and dispersing agent comprises an anchoring group which forms a salt of a cationic spec and anionic species.

The cationic species of the anchoring group is selected from the group consisting of primary ammonium, secondary ammonium, tertiary ammonium, quaternary ammonium, and a combination of any of these.

In a preferred embodiment of the present invention, the anionic species of the anchoring group is selected from the group consisting of halogen, phosphate, carboxylate, sulfonate, phosphonate and a combination of any of these.

More preferably, the anchoring group of the wetting and dispersing agent is a quaternary ammonium salt represented by following chemical formula (I),

-N⁺R₁R₂R₃ X⁻ (I)

(Wherein the chemical formula (I), R₁ is a hydrogen atom, alkyl group having 1 to 30 carbon atoms, or an aryl group having 1 to 30 carbon atoms; R₂ is a hydrogen atom, alkyl group having 1 to 30 carbon atoms, or an aryl group having 1 to 30 carbon atoms; R₃ is a hydrogen atom, alkyl group having 1 to 30 carbon atoms, or an aryl group having 1 to 30 carbon atoms; R₁, R₂ and R₃ can be same or different of each other, X is an anion selected from the group consisting of F, CI, Br, I, phosphate, carboxylate, sulfonate,and phosphonate.)

Even more preferably, R₁ is a hydrogen atom or an alkyl group having 1 to 30 carbon atoms; R₂ is a hydrogen atom or an alkyl group having 1 to 30 carbon atoms; R3 is a hydrogen atom or an alkyl group having 1 to 30 carbon atoms; R₁, R₂ and R₃ can be same or different of each other.

In a preferred embodiment of the present invention, the wetting and dispersing agent is attached directly onto the surface of the nanosized fluorescent material. By using ligand exchange method, described in for example, Thomas Nann, Chem. Commun., 2005, 1735 - 1736, DOI: 10.1039/b-414807j, the wetting and dispersing agent can be introduced onto the surface of the nanosized fluorescent material.

According to the present invention, the weight-average molecular weight of the wetting and dispersing agent is not particularly limited.
Preferably, it is in the range from 2,000 - 100,000, more preferably, it is in the range from 5,000 - 30,000 from the view point of better dispersivity and film strength.

According to the present invention, the molecular weight M_{w} is determined by means of GPC (= gel permeation chromatography) against an internal polystyrene standard.

As the wetting and dispersing agents, commercially available wetting and dispersing agents comprising an anchoring group which forms salt, can be used preferably. Such as BYK-180 ([trademark], from BYK com.), DA-325, DA-7301 (Kusumoto chemicals, Ltd.)

### - Nanosized fluorscent materials

According to the present invention, any type of publically known nanosized fluorescent material can be used.

In a preferred embodiment of the present invention, the nanosized fluorescent material is selected from the group consisting of nanosized inorganic phosphor materials, quantum sized materials such as quantum dots and or quantum rods and a combination of any of these.

Without wishing to be bound by theory, it is believed that the nanosized fluorescent material can be used in a higher concentration ratio due to size effect and also may realize sharp vivid color(s) of a color conversion medium such as a color conversion film.

More preferably, the nanosized fluorescent material is a quantum sized material, with furthermore preferably being of a quantum dot material, quantum rod material or a combination of any of these.

According to the present invention, the term "nanosized" means the size in between 1 nm and 999 nm.

Thus, according to the present invention, the nanosized fluorescent material is taken to mean that the fluorescent material which size of the overall diameter is in the range from 1 nm to 999 nm. And in case of the material has elongated shape, the length of the overall structures of the fluorescent material is in the range from 1 nm to 999 nm.

According to the present invention, the term "quantum sized" means the size of the inorganic semiconductor material itself without ligands or another surface modification, which can show the quantum size effect.

Generally, quantum sized material such as quantum dot material, and / or quantum rod material can emit sharp vivid colored light due to quantum size effect.

In a preferred embodiment of the present invention, the quantum sized material is selected from the group consisting of II-VI, III-V, or IV-VI semiconductors and combinations of any of these.

More preferably, the quantum sized material is selected from the groups consisting of Cds, CdSe, CdTe, ZnS, ZnSe, ZnTe, ZnO, GaAs, GaP, GaAs, GaSb, HgS, HgSe, HgSe, HgTe, InAs, InP, InPZn, InPZnS, InSb, AlAs, AlP, AlSb, Cu₂S, Cu₂Se, CuInS2, CuInSe₂, Cu₂(ZnSn)S₄, Cu₂(InGa)S₄, TiO₂ alloys and combination of any of these, can be used preferably.

For example, for red emission use CdSe/CdS, CdSeS/CdZnS, CdSeS/CdS/ZnS, ZnSe/CdS, CdSe/ZnS, InP/ZnS, InP/ZnSe, InP/ZnSe/ZnS, InPZn/ZnS, InPZn/ZnSe/ZnS dots or rods, ZnSe/CdS, ZnSe/ZnS or combination of any of these, can be used preferably.

For example, for green emission use CdSe/CdS, CdSeS/CdZnS, CdSeS/CdS/ZnS, ZnSe/CdS, CdSe/ZnS, InP/ZnS, InP/ZnSe, InP/ZnSe/ZnS, InPZn/ZnS, InPZn/ZnSe/ZnS, ZnSe/CdS, ZnSe/ZnS or combination of any of these can be used preferably.
and for blue emission use, such as ZnSe, ZnS, ZnSe/ZnS, or combination of any of these, can be used.

As a quantum dot, publically available quantum dot, for examples, CdSeS/ZnS alloyed quantum dots product number 753793, 753777, 753785, 753807, 753750, 753742, 753769, 753866, InP/ZnS quantum dots product number 776769, 776750, 776793, 776777, 776785, PbS core-type quantum dots product number 747017, 747025, 747076, 747084, or CdSe/ZnS alloyed quantum dots product number 754226, 748021, 694592, 694657, 694649, 694630, 694622 from Sigma-Aldrich, can be used preferably as desired.

In some embodiments, the semiconductor nanocrystal can be selected from a anisotropic shaped structure, for example quantum rod material to realize better out-coupling effect (for example ACS Nano, 2016, 10(6), pp 5769-5781).

Examples of quantum rod material have been described in, for example, the international patent application laid-open No.WO2010/095140A.

In a preferred embodiment of the invention, the length of the overall structures of the quantum sized material, such as a quantum rod material / or the quantum dot material, is from 1 nm to 500 nm, preferably, from 1 nm to 160 nm, even more preferably, from 1 nm to 20 nm, most preferably, it is from 1 nm to 10 nm.

Preferably, the nanosized fluorescent material such as quantum rod and / or quantum dot comprises a surface ligand.
The surface of the quantum rod and / or quantum dot materials can be over coated with one or more kinds of surface ligands.

Without wishing to be bound by theory it is believed that such a surface ligands may lead to disperse the nanosized fluorescent material in a solvent more easily.

The wetting and dispersing agent can be attached onto the surface of the ligand of the nanosized fluorescent material or directly attached onto the surface of the nanosized fluorescent material partially or fully by using ligand exchange process as described in the section named "Wetting and dispersing agents".

According to the present invention, preferably, the photosensitive composition can be a green type photosensitive composition containing the plurality of the green visible light emittable nanosized fluorescent materials, red type photosensitive composition comprising the plurality of the red visible light emittable nanosized fluorescent materials, or white type photosensitive composition containing the plurality of the different kinds of nanosized fluorescent materials, such as a mixture of the green visible light emittable nanosized fluorescent materials and the red light emittable nanosized fluorescent materials, a mixture of blue visible light emittable nanosized fluorescent materials and the red light emittable nanosized fluorescent materials, or a mixture of blue, green, and red light emittable nanosized fluorescent materials.

### - Polymer matrix

According to the present invention, the polymer is selected from (meth)acrylic polymers to realize lower temprerature method for preparation of color conversion medium to save energy in the preparaton and / or to prevent quenching of the plurality of nanosized fluorescent materials.,

### - (Meth)acrylic polymers

According to the present invention, the term "(meth)acrylic polymer" means a general term of polymer obtained by polymerization of monomers selected from the group consisting of acrylic acid, methacrylic acid, acrylate, methacrylate, and a combination of any of these.

As the (meth)acrylic polymer of the present invention, publically known one or more of (meth)acrylic polymers can be used.

In some embodiments of the present invention, preferably, the (meth)acrylic polymer can comprise a (meth)acrylic unit including an acid group.

In a preferred embodiment of the present invention, the (meth)acrylic unit including an acid group is a (meth)acrylic unit including a side chain selected from the group consisting of carboxyl group, sulfo group, or phenol type hydroxyl group.

Without wishing to be bound by theory, it is believed that the (meth)acrylic polymer which includes a (meth)acrylic unit including an acid group may lead to better solubility of the uncured part of the photosensitive composition to a developer.

According to the present invention, the number of the acid group is not particularly limited. From reconcile better reactivity and storage stability of the photosensitive composition, the acid value of the (meth)acrylic polymer is in the range from 5 to 500 mg KOH/g preferably. More preferably, it is from 50 mg KOH/g to 300 mg KOH/g.

According to the present invention, the (meth)acrylic polymer comprises a silane modified (meth)acrylic unit.

As the examples of the silane modified (meth)acrylic unit, siloxy group and / or silanol group substituted (meth)acrylic unit, (meth)acrylic unit fabricated by reaction with a silane coupling agent including carbon-carbon unsaturated bond, silicone oligomer, silicone oil can be used preferably.

More preferably, a copolymer made from silane coupling agent and (meth)acrylic polymers having a (meth)acrylic unit including an acid group is used.

Here, as the examples of the silane coupling agent, KBM-1003, KME-1003, KBM-1403 or KBM-5103 (from Shinetsu. Co.), and as the examples of the silicone oil, X-22-174DX, X-22-2426, X-22-2475, or X-22-1602 (from Shinetsu. Co.) can be used preferably.

By changing the molar ratio of (meth)acrylic unit including an acid group and the silane modified (meth)acrylic unit in the (meth)acrylic polymer, solubility of the (meth)acrylic polymer in an alkali developer can be adjusted as desired.

In a preferred embodiment of the present invention, the molar ratio of the (meth)acrylic unit including an acid group and the silane modified (meth)acrylic unit in the (meth)acrylic polymer can be from 95 : 5 ((meth)acrylic unit including an acid group : the silane modified (meth)acrylic unit) to 30: 70 ((meth)acrylic unit including an acid group : the silane modified (meth)acrylic unit), from the view point of better solubility in an alkali developer, good development property of the photosensitive composition comprising a plurality of nanosized fluorescent material, a (meth)acrylic polymer and a wetting and dispersing agent.

More preferably, it can be from 90 : 10 ((meth)acrylic unit including an acid group : the silane modified (meth)acrylic unit) to 50 : 50 ((meth)acrylic unit including an acid group : the silane modified (meth)acrylic unit).

According to the present invention, the number of the unsaturated bond of the silane modified (meth)acrylic unit is not particularly limited. From reconcile better reactivity and compatibility with another ingredients of the photosensitive composition, the value of double bond equivalent (ethylenically unsaturated bond equivalent) in the (meth)acrylic polymer is in the range from 1 to 500 g / eq preferably.

In another embodiments of the present invention, the (meth)acrylic polymer can be a (meth)acrylic polymer which includes a repeating unit containing acid group.

As the (meth)acrylic polymer which includes a repeating unit containing acid group, (meth)acrylic polymer including a side chain selected from the group consisting of carboxyl group, sulfo group, or phenol type hydroxyl group.

According to the present invention, the number of the acid group is not particularly limited. From reconcile better reactivity and storage stability of the photosensitive composition, the acid value of the (meth)acrylic polymer is in the range from 5 to 500 mg KOH/g preferably. More preferably, it is from 50 mg KOH/g to 300 mg KOH/g.

According to the present invention, the weight-average molecular weight of the (meth)acrylic polymer is not particularly limited.
Preferably, it is in the range from 2,000 - 100,000, more preferably, it is in the range from 3,000 - 30,000.

As the examples of the silane modified (meth)acrylic polymer, siloxy group and / or silanol group substituted (meth)acrylic polymers, (meth)acrylic polymers reacted with a silane coupling agent including carbon-carbon unsaturated bond, silicone oligomer, or silicone oil can be used preferably.

More preferably, a copolymer made from silane coupling agent and (meth)acrylic polymers can be used as the silane modified (meth)acrylic polymer.
Here, as the examples of the silane coupling agent, KBM-1003, KME-1003, KBM-1403 or KBM-5103 (from Shinetsu. Co.), and as the examples of the silicone oil, X-22-174DX, X-22-2426, X-22-2475, or X-22-1602 (from Shinetsu. Co.) can be used preferably.

According to the present invention, the number of the unsaturated bond is not particularly limited. From reconcile better reactivity and compatibility, the value of double bond equivalent (ethylenically unsaturated bond equivalent) in the (meth)acrylic polymer is in the range from 10 to 500 g / eq preferably.

In a preferred embodiment of the present invention, the molar ratio of the (meth)acrylic polymer including an acid group and the silane modified (meth)acrylic polymer in the photosensitive composition can be from 95 : 5 ((meth)acrylic polymer including an acid group : the silane modified (meth)acrylic polymer) to 30: 70 ((meth)acrylic polymer including an acid group : the silane modified (meth)acrylic polymer), from the view point of better solubility in an alkali developer, good development property of the photosensitive composition comprising a plurality of nanosized fluorescent material, a (meth)acrylic polymer and a wetting and dispersing agent.

More preferably, it can be from 90 : 10 ((meth)acrylic polymer including an acid group : the silane modified (meth)acrylic polymer) to 50 : 50 ((meth)acrylic polymer including an acid group : the silane modified (meth)acrylic polymer).

According to the present invention, the photosensitive composition can be either a positive-type photosensitive composition or a negative-type photosensitive composition.

### - Positive-type photosensitive composition

The photosensitive composition according to the present invention can further comprise a positive-type photosensitive material so that the photosensitive composition can function as a positive-type photosensitive composition.

### - Positive-type photosensitive material

If the photosensitive material has an effect on the photosensitive composition of the present invention to make it developable so that the composition spread in an exposed area can be soluble in an alkali developer, the photosensitive composition containing the photosensitive material serves as a positive-type photosensitive composition.

Preferred examples of the photosensitive material having the above effect include diazonaphthoquinone derivatives, which are esters of phenolic hydroxyl-containing compounds with naphthaquinonediazidesulfonic acids.

There are no particular restrictions on the structure of the diazo-naphtoquinone derivative, the derivative is preferably an ester compound derived from a compound having one or more phenolic hydroxyl groups. Examples of the naphtha quinonediazidesulfonic acids include 4-naphthoquinonediazidesulfonic acid and 5-naphthoquinonediazidesulfonic acid. Since having an absorption band in the wavelength range of i-line light (wavelength: 365 nm), the 4-naphthoquinonediazidesulfonic ester compound is suitable for i-line light exposure. On the other hand, since having an absorption band in a wide wavelength range, the 5-naphthoquinonediazidesulfonic ester compound is suitable for exposure in a wide wavelength range. Accordingly, it is preferred to select 4- or 5-naphthoquinonediazidesulfonic ester compound according to the wavelength for exposure. It is also possible to use both of them in combination.
There are no particular restrictions on the phenolic hydroxyl-containing compound. Examples thereof are shown as follows (in which all the compound names except "bisphenol A" are trade names [trademark] manufactured by HONSHU CHEMICAL INDUSTRY CO., LTD.).

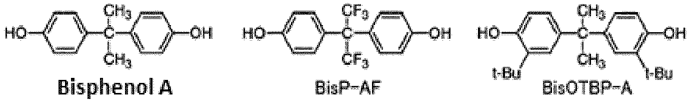

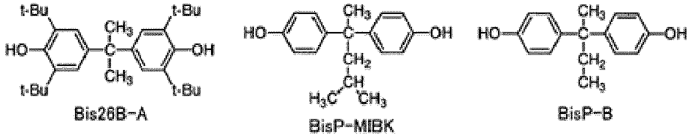

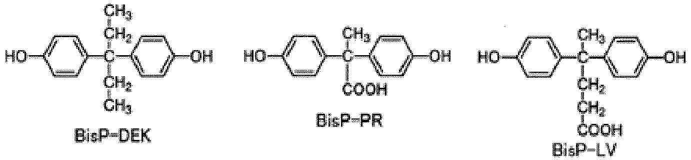

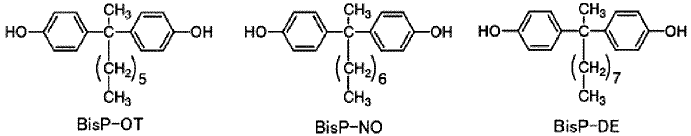

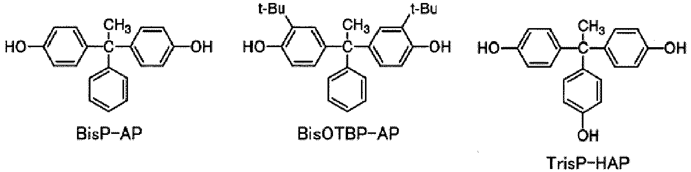

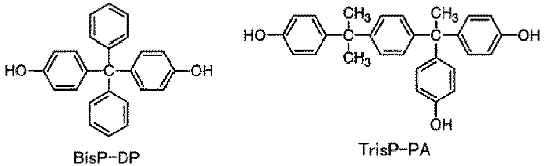

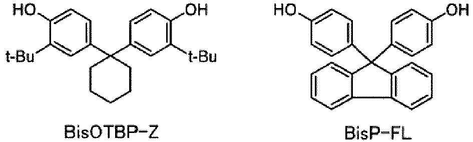

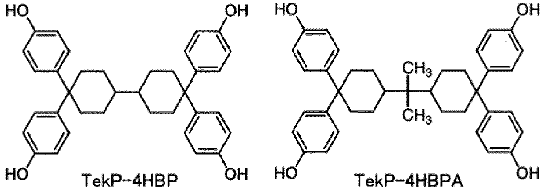

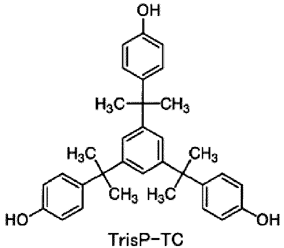

### - Negative-type photosensitive composition

According to the present invention, if the photosensitive composition does not contain any positive-type photosensitive composition, then the photosensitive composition serves as a negative-type photosensitive composition.

In some embodiments of the present invention, preferably, the photo sensitive composition is a negative type photosensitive composition comprising a polymerization initiator.

### - Polymerization initiator

In a preferred embodiment of the present invention, the photosensitive composition can further contain a polymerization initiator. Generally, there are two kinds of polymerization initiators which can be used in the present invention: one is a polymerization initiator generating an acid, base, or radical when exposed to radiation, and the other is a polymerization initiator generating an acid, base or radical when exposed to heat.

Without wishing to be bound by theory, it is believed that the polymerization initiator can reinforce the pattern shape or can increase contrast in development to improve the resolution. And also it is believed that the polymerization initiator can lead better polymerization of matrix material and results in better shape of the color conversion medium.

The polymerization initiator adoptable in the present is, for example, a photo acid-generator, which decomposes when exposed to radiation and releases an acid serving as an active substance for photo-curing the composition; a photo radical - generator, which releases a radical; a photo base-generator, which releases a base; a heat acid-generator, which decomposes when exposed to heat and releases an acid serving as an active substance for heat-curing the composition; a heat radical - generator, which releases a radical; and a heat base-generator, which releases a base. Examples of the radiation include visible light, UV rays, IR rays, X-rays, electron beams, α-rays and γ-rays.

The optimal amount of the polymerization initiator depends on the kind of the active substance released from the decomposed initiator, on the amount of the released substance, on the required sensitivity and on the dissolution contrast between the exposed and unexposed areas.

In a preferred embodiment of the present invention, the amount of the polymerization initiator is in the range from 0.001 to 10 weight parts, more preferably 0.01 to 5 weight parts, based on 100 weight parts of the (meth)acrylic polymer. More than 0.001 weight part is preferable to realize the better dissolution contrast between the exposed and unexposed areas and to obtain the effect of the initiator. On the other hand, less than 10 weight parts of the polymerization initiator is preferable to prevent cracks of the fabricated color conversion medium (100), or coloring of the fabricated film caused by decomposition of the initiator and to realize good resistance of the coating against a photoresist remover.

Examples of the above photo acid-generator include diazomethane compounds, diphenyliodonium salts, triphenylsulfonium salts, sulfonium salts, ammonium salts, phosphonium salts and sulfonamide compounds. The structures of those photo acid-generators can be represented by the formula (A):

R⁺X⁻ (A).

Wherein the formula (A), R⁺ is hydrogen or an organic ion modified by carbon atoms or other hetero atoms provided that the organic ion is selected from the group consisting of alkyl groups, aryl groups, alkenyl groups, acyl groups and alkoxy groups. For example, R⁺ is diphenyliodonium ion or triphenylsulfonium ion.

Further, X⁻ is preferably a counter ion represented by any of the following formulas:
SbY₆⁻,
ASY₆⁻,
R^{a}ₚPY₆₋ₚ⁻,
R^{a}_{q}BY_{4-q}⁻,
R^{a}_{q}GaY_{4-q}⁻,
R^{a}SO₃⁻,
(R^{a}SO₂)₃C⁻,
(R^{a}SO₂)₂N⁻,
R^{a}COO⁻, and
SCN⁻
in which
Y is a halogen atom,
R^{a} is an alkyl group of 1 to 20 carbon atoms or an aryl group of 6 to 20 carbon atoms provided that each group is substituted with a substituent group selected from the group consisting of fluorine, nitro group and cyano group,

p is a number of 0 to 6, and
q is a number of 0 to 4.

Concrete examples of the counter ion include: BF₄⁻, (C₆F₅)₄B⁻, ((CF₃)₂C₆H₃)₄B⁻, PF₆⁻, (CF₃CF₂)₃PF₃⁻, SbF₆⁻, (C₆F₅)₄Ga⁻, ((CF₃)₂C₆H₃)₄Ga⁻, SCN⁻, (CF₃SO₂)₃C⁻, (CF₃SO₂)₂N⁻, formate ion, acetate ion, trifluoromethanesulfonate ion, nonafluorobutanesulfonate ion, methanesulfonate ion, butanesulfonate ion, benzenesulfonate ion, p-toluenesulfonate ion, and sulfonate ion.

Among the photo acid-generators usable in the present invention, those generating sulfonic acids or boric acids are particularly preferred.

Examples thereof include tricumyliodonium teterakis(pentafluorophenyl)-borate (PHOTOINITIATOR2074 [trademark], manufactured by Rhodorsil), diphenyliodonium tetra(perfluorophenyl)borate, and a compound having sulfonium ion and pentafluoroborate ion as the cation and anion moieties, respectively. Further, examples of the photo acid-generators also include triphenylsulfonium trifluoromethanesulfonate, triphenylsulfonium camphorsulfonate, triphenylsulfonium tetra(perfluorophenyl)borate, 4-acetoxyphenyldimethylsulfonium hexafluoroarsenate, 1-(4-n-butoxynaphthalene-1-yl)tetrahydrothiophenium trifluoromethanesulfonate, 1-(4,7-dibutoxy-1-naphthalenyl)tetrahydrothiophenium trifluoromethanesulfonate, diphenyliodonium trifluoromethanesulfonate, and diphenyliodonium hexafluoroarsenate. Furthermore, it is still also possible to adopt photo acid-generators represented by the following formulas: 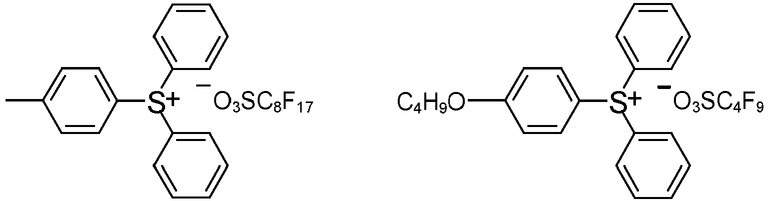 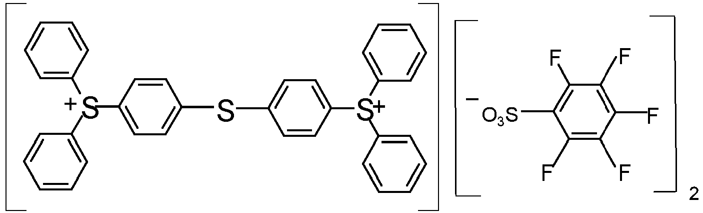 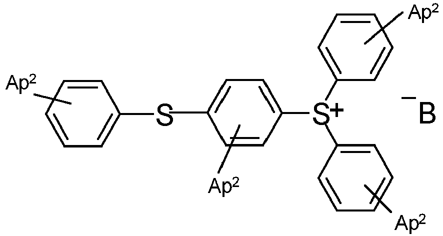 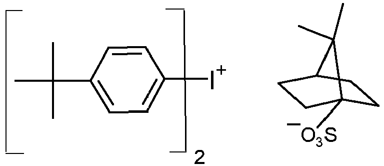 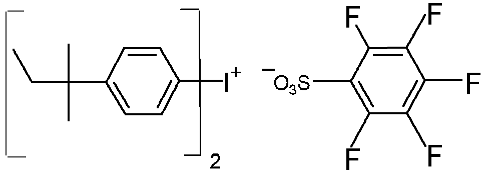 in which
each A is independently a substituent group selected from the group consisting of an alkyl group of 1 to 20 carbon atoms, an alkoxy group of 1 to 20 carbon atoms, an aryl group of 6 to 20 carbon atoms, an alkylcarbonyl group of 1 to 20 carbon atoms, an arylcarbonyl group of 6 to 20 carbon atoms, hydroxyl group, and amino group;
each p² is independently an integer of 0 to 5; and
B⁻ is a fluorinated alkylsulfonate group, a fluorinated arylsulfonate group, a fluorinated alkylborate group, an alkylsulfonate group or an arylsulfonate group.

It is also possible to use photo acid-generators in which the cations and anions in the above formulas are exchanged each other or combined with various other cations and anions described above. For example, any one of the sulfonium ions represented by the above formulas can be combined with tetra(perfluorophenyl)borate ion, and also any one of the iodonium ions represented by the above formulas can be combined with tetra(perfluoro-phenyl)borate ion. Those can be still also employed as the photo acid-generators.

The heat acid-generator is, for example, a salt or ester capable of generating an organic acid. Examples thereof include: various aliphatic sulfonic acids and salts thereof; various aliphatic carboxylic acids, such as, citric acid, acetic acid and maleic acid, and salts thereof; various aromatic carboxylic acids, such as, benzoic acid and phthalic acid, and salts thereof; aromatic sulfonic acids and ammonium salts thereof; various amine salts; aromatic diazonium salts; and phosphonic acid and salts thereof. Among the heat acid-generators usable in the present invention, salts of organic acids and organic bases are preferred, and further preferred are salts of sulfonic acids and organic bases.

Examples of the preferred heat acid-generators containing sulfonate ions include p-toluenesulfonates, benzenesulfonates, p-dodecylbenzenesulfonates, 1,4-naphthalenedisulfonates, and methanesulf

Examples of the photo radical-generator include azo compounds, peroxides, acyl phosphine oxides, alkyl phenons, oxime esters, and titanocenes.

According to the present invention, as the photo radical-generator, acyl phosphine oxides, alkyl phenons, oxime esters, or a combination of any of these are more preferable. For examples, 2,2-dimethxye-1,2-diphenylethane-1-on, 1-hydroxy-cyclohexylphenylketone, 2-hydroxy-2-methyl-1-phenylpropan-1-on, 1-[4-(2-hydroxyethoxy)phenyl]-2-hydroxy-2-methyl-1-propane-1-on, 2-hydroxy-1-{4-[4-(2-hydroxy-2-methylpropionyl)benzyl]phenyl}-2-methylpropane-1-on, 2-methyl-1-(4-methylthiophenyl)-2-morpholinopropane-1-on, 2-benzyl-2-dimethylamino-1-(4-morpholinophenyl)-1-butanone, 2-(dimethylamino) -2-[(4-methylphenon)methyl]-1-[4-(4-morpholinyl)phenyl]-1-butanone, 2,4,6-trimethylbenzoyl-diphenylphosphine oxide, bis(2,4,6-trimethylbenzoyl)phenylphosphine oxide, 1,2-octanedione 1-[4-(phenylthio)-2-(o-benzoyl oxime)], ethanone 1-[9-ethyl-6-(2-methylbenzoyl)-9H-carbazole-3-yl]-1-(o-acetyl oxime) or a combination of any of these can be used preferably.

As the examples of the heat radical-generator, 2,2' azobis(2-methylvaleronitrile), 2,2'-azobis(dimethylvaleronitrile) or a combination of any of these can be used preferably.

Examples of the photo base-generator include multi-substituted amide compounds having amide groups, lactams, imide compounds, and compounds having those structures.

Examples of the above heat base-generator include: imidazole derivatives, such as, N-(2-nitrobenzyloxycarbonyl)imidazole, N-(3-nitrobenzyloxycarbonyl)imidazole, N-(4-nitrobenzyloxycarbonyl)imidazole, N-(5-methyl-2-nitrobenzyloxycarbonyl)imidazole, and N-(4-chloro-2-nitrobenzyloxycarbonyl)imidazole; 1,8-diazabicyclo(5,4,0)undecene-7, tertiary amines, quaternary ammonium salts, and mixture thereof. Those base-generators as well as the acid-generators and / or radical - generators can be used singly or in mixture.

According to the present invention, a polymerization initiator generating an acid, base, or radical when exposed to radiation can be used preferably.

Thus, in a preferred embodiment of the present invention, the polymerization initiator is selected from the group consisting of a photo radical-generator, photo base-generator, photo acid-generator, and a combination of any of these.

More preferably, the polymerization initiator is a photo radical-generator.

### - Solvents

According to the present invention, a wide variety of publically known solvents can be used. There are no particular restrictions on the solvent as long as it can homogeneously dissolve or disperse the above a (meth)acrylic polymer. And preferably, it can homogeneously dissolve or disperse the polymerization initiator, and additives incorporated optionally.

Thus, in some embodiments of the present invention, preferably, the photosensitive composition can further comprise a solvent.

In a preferred embodiment of the present invention, the solvent is selected from the group consisting of ethylene glycol monoalkyl ethers, such as, ethylene glycol monomethyl ether, ethylene glycol monoethyl ether, ethylene glycol monopropyl ether, and ethylene glycol monobutyl ether; diethylene glycol dialkyl ethers, such as, diethylene glycol dimethyl ether, diethylene glycol diethyl ether, diethylene glycol dipropyl ether, and diethylene glycol dibutyl ether; ethylene glycol alkyl ether acetates, such as, methyl cellosolve acetate and ethyl cellosolve acetate; propylene glycol alkyl ether acetates, such as, propylene glycol monomethyl ether acetate (PGMEA), propylene glycol monoethyl ether acetate, and propylene glycol monopropyl ether acetate; aromatic hydrocarbons, such as, benzene, toluene and xylene; ketones, such as, methyl ethyl ketone, acetone, methyl amyl ketone, methyl isobutyl ketone, and cyclohexanone; alcohols, such as, ethanol, propanol, butanol, hexanol, cyclohexanol, ethylene glycol, and glycerin; esters, such as, ethyl 3-ethoxypropionate, methyl 3-methoxypropionate and ethyl lactate; and cyclic asters, such as, γ-butyrolactone. Those solvents are used singly or in combination of two or more, and the amount thereof depends on the coating method and the thickness of the coating.

More preferably, propylene glycol alkyl ether acetates, such as, propylene glycol monomethyl ether acetate (hereafter "PGMEA"), propylene glycol monoethyl ether acetate, or propylene glycol monopropyl ether acetate is used.
Even more preferably, PGMEA is used.

The amount of the solvent in the photosensitive composition can be freely controlled according to the method of coating the composition. For example, if the composition is to be spray-coated, it can contain the solvent in an amount of 90 wt. % or more. Further, if a slit-coating method, which is often adopted in coating a large substrate, is to be carried out, the content of the solvent is normally 60 wt. % or more, preferably 70 wt. % or more.

### - Chemical compound including two or more of (meth)acryloyl groups

In some embodiments of the present invention, preferably, the photosensitive composition further comprises a chemical compound including two or more of (meth)acryloyl groups.

According to the present invention, the term "(meth)acryloyl group" means a general term of acryloyl group and methacryloyl group.

The chemical compound including two or more of (meth)acryloyl groups can react with the (meth)acrylic polymer, and then can create a crosslinking structure.

Preferably, the chemical compound comprises three or more of (meth)acryloyl groups to create a higher dimension crosslinking structure together with the (meth)acrylic polymer.
As examples of the chemical compound including two or more of (meth)acryloyl groups, esters formed by reacting of a polyol and two or more of (meth)acrylic acid can be used preferably in the present invention.

According to the present invention, the polyol has a basic structure selected from the group consisting of a saturated or unsaturated aliphatic hydrocarbon, aromatic hydrocarbon, heterocyclic hydrocarbon, primary, secondary, or tertiary amine, ether, and two or more of substituents of hydroxyl group. The polyols of the present invention can further include additional substituent like disclosed in for example, JP 2014-114176.

As publically available functional acrylates, bifunctional acrylates, multifunctional acrylates such as A-DOD, A-DCP, and / or A-9300 (from Shin-Nakamura Chemical Co., Ltd.) can be used singly or in mixture preferably.

In a preferred embodiment of the present invention, the amount of the chemical compound comprises three or more of (meth)acryloyl groups is in the range from 0.001 to 90 weight parts based on 100 weight parts of the (meth)acrylic polymer, more preferably 3 to 60 weight parts to realize better solubility with other polymers used in the photosensitive composition of the present invention. Even more preferably, it is in the range from 5 to 50 weight parts based on 100 weight parts of the (meth)acrylic polymer.

### - Scattering particles and / or reflective index adjusting materials

In some embodiments of the present invention, the photosensitive composition can further comprise additives selected from the group consisting of scattering particles, reflective index adjusting material and a combination of any of these.

According to the present invention, as the light scattering particles, any type of publically known light scattering particles having different refractive index from the matrix material of the layer which includes the said light scattering particles and can give Mie scattering effects, can be used preferably as desired.
For examples, small particles of inorganic oxides such as SiO₂, SnO₂, CuO, CoO, Al₂O₃ TiO₂, Fe₂O₃, Y₂O₃, ZnO, MgO; organic particles such as polymerized polystyrene, polymerized PMMA; inorganic hollow oxides such as hollow silica or a combination of any of these; can be used preferably.

Aforementioned the light scattering particles can be used as the index adjusting material.

Preferably, the average particle diameter of the light scattering particles and or the reflective index adjusting material can be in the range from 350 nm to 5 µm.
Without wishing to be bound by theory, it is believed that more than 350 nm average particle diameter may lead to strong forward scattering caused by Mie scattering in a later, even if the refractive index difference between the light scattering particles and the layer matrix is as small as 0.1.

On the other hand, to obtain better layer forming properties by using the light scattering particles (150), maximum average particle diameter is 5 um or less, preferably. More preferably, from 500 nm to 2 µm.

### - Other additives

The photosensitive composition of the present invention may contain other additives, if necessary. Examples of the additives include developer-dissolution promoter, scum remover, adhesion enhancer, polymerization inhibitor, defoaming agent, surfactant and sensitizer.

The developer-dissolution promoter or the scum remover has a function of controlling solubility of the formed coating in a developer and thereby of preventing scum from remaining on the substrate after development. As this additive, crown ethers can be adopted. Crown ethers having the simplest structures are represented by the general formula: (-CH₂-CH₂-O-)ₙ. Among them, crown ethers of the formula in which n is 4 to 7 are preferably used in the present invention. Meanwhile, crown ethers are often individually referred to as "x-crown-y-ether" in which x and y represent the total number of atoms forming the ring and the number of oxygen atoms included therein, respectively. In the present invention, the additive can be preferably selected from the group consisting of crown ethers of X=12, 15, 18 and 21 and y=x/3, benzo-condensed products thereof, and cyclohexyl-condensed products thereof. Preferred examples of the crown ethers include 21-crown-7-ether, 18-crown-6-ether, 15-crown-5-ether, 12-crown-4-ether, dibenzo-21-crown-7-ether, dibenzo-18-crown-6-ether, dibenzo-15-crown-5-ether, dibenzo-12-crown-4-ether, dicyclohexyl-21-crown-7-ether, dicyclohexyl-18-crown-6- ether, dicyclohexyl-15-crown-5-ether, and dicyclohexyl- 12-crown-4-ether. Among them, it is particularly preferred to select the additive from the group consisting of 18-crown-6-ether and 15-crown-5-ether. The amount thereof is preferably 0.05 to 15 weight parts, more preferably 0.1 to 10 weight parts, based on 100 weight parts of the (meth)acrylic polymer.

The adhesion enhancer has a function of preventing the pattern from being peeled off by stress applied after curing when a cured film is formed from the photosensitive composition of the present invention. As the adhesion enhancer, imidazoles and silane coupling agents are preferably adopted. Examples of the imidazoles include 2-hydroxybenzimidazole, 2-hydroxyethylbenzimidazole, benzimidazole, 2-hydroxyimidazole, imidazole, 2-mercaptoimidazole, and 2-aminoimidazole. Among them, particularly preferred are 2-hydroxybenzimidazole, benzimidazole, 2-hydroxyimidazole and imidazole.

As the silane coupling agents, known compounds, such as, epoxy-silane coupling agents, amino-silane coupling agents and mercapto-silane coupling agents, can be preferably adopted. Examples thereof include 3-glycidoxypropyltrimethoxysilane, 3-glycidoxypropyltriethoxysilane, N-2-(aminoethyl)-3-aminopropyltrimethoxysilane, N-2-(aminoethyl)-3-aminopropyltriethoxysilane, 3-aminopropyltrimethoxysilane, 3-aminopropyltriethoxysilane, 3-ureidopropyltrimethoxysilane, 3-chloropropyltrimethoxysilane, 3-mercaptopropyltrimethoxysilane, and 3-isocyanatepropyltrimethoxysilane. Those can be used singly or in combination of two or more. The amount thereof is preferably 0.05 to 15 weight parts based on 100 weight parts of the (meth)acrylic polymer.

It is also possible to employ a silane or siloxane compound having an acidic group as the silane coupling agent. Examples of the acidic group include carboxyl group, an acid anhydride group, and phenolic hydroxyl group. If having a monobasic acid group such as carboxyl or phenolic hydroxyl group, the compound is preferably a single silicon-containing compound having two or more acidic groups.

Examples of the above silane coupling agent include compounds represented by the following formula (B):

XₙSi(OR⁴)₄₋ₙ (B)

and polymers having polymerization units derived from them. Those polymers may comprise plural kinds of units different in X or R³ in combination.

In the above formula, R⁴ is a hydrocarbon group, such as, an alkyl group, preferably having 1 to 10 C atoms. Examples thereof include methyl, ethyl, n-propyl, iso-propyl and n-butyl groups. The formula (A) contains plural R⁴s, which may be the same or different from each other.

In the above formula, X includes an acidic group, such as, thiol, phosphonium, borate, carboxyl, phenol, peroxide, nitro, cyano, sulfo or alcohol group. The acidic group may be protected with a protective group, such as, acetyl, aryl, amyl, benzyl, methoxymethyl, mesyl, tolyl, trimethoxysilyl, triethoxysilyl, triisopropylsilyl or trityl group. Further, X may be an acid anhydride group.

Among the above, R⁴ and X are preferably methyl group and a carboxylic acid anhydride group, respectively. For example, an acid anhydride group-containing silicone is preferred. Concrete examples thereof are a compound represented by the following formula (B-1) (X-12-967C [trademark], manufactured by Shin-Etsu Chemical Co., Ltd.) and a silicon-containing polymer, such as silicone, having a structure corresponding the formula at the terminal or in the side chain and having a weight average molecular weight of 1000 or less. Also preferred is a dimethyl silicone having a weight average molecular weight of 4000 or less and having a terminal modified with an acidic group, such as, thiol, phosphonium, borate, carboxyl, phenol, peroxide, nitro, cyano or sulfo group. Examples thereof include compounds represented by the following formulas (B-2) and (B-3) (X-22-2290AS and X-22-1821 [trademark], manufactured by Shin-Etsu Chemical Co., Ltd.).

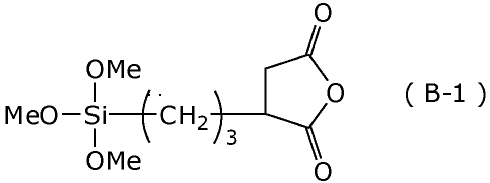

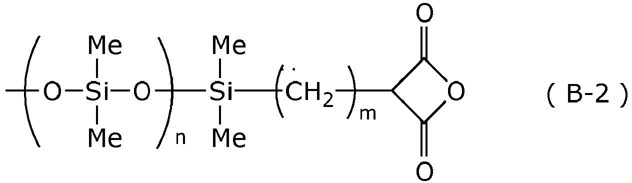

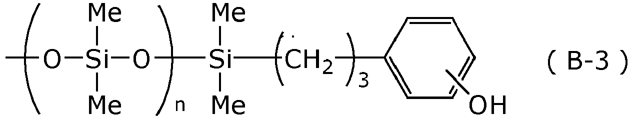

If the silane coupling agent contains a silicone structure and has too large a molecular weight, it has poor compatibility with the composition. Consequently, the coating is dissolved in a developer so insufficiently that reactive groups may remain in the coating. This may cause problems in that, for example, the coating cannot have enough chemical resistance against post-processes. In view of that, the silicon-containing compound has a weight average molecular weight of preferably 5000 or less, more preferably 1000 to 4000. Further, if the acidic group-containing silane or siloxane compound is employed as the silane coupling agent, the amount thereof is preferably 0.01 to 15 weight parts based on 100 weight parts of the (meth)acrylic polymer in the photosensitive composition.

As the polymerization inhibitor, nitrone derivatives, nitroxide radical derivatives and hydroquinone derivatives, such as, hydroquinone, methylhydroquinone and butyllhydroquinine, can be incorporated. Those can be used singly or in combination of two or more. The amount thereof is preferably 0.1 to 10 weight parts based on 100 weight parts of the (meth)acrylic polymer.

Examples of the defoaming agent include: alcohols (C₁ to C₁₈); higher fatty acids, such as, oleic acid and stearic acid; higher fatty acid esters, such as, glycerin monolaurate; polyethers, such as, polyethylenglycol (PEG) (Mn: 200 to 10000) and polypropyleneglycol (Mn: 200 to 10000); silicone compounds, such as, dimethyl silicone oil, alkyl-modified silicone oil and fluoro-silicone oil; and organic siloxane surfactants described below in detail. Those can be used singly or in combination of two or more. The amount thereof is preferably 0.1 to 3 weight parts based on 100 weight parts of the (meth)acrylic polymer.

If necessary, the photosensitive composition of the present invention can further contain a surfactant, which is incorporated with the aim of improving coatability, developability and the like. The surfactants usable in the present invention are, for example, nonionic, anionic and amphoteric surfactants.

Examples of the nonionic surfactants include: polyoxyethylene alkyl ethers, such as, polyoxyethylene lauryl ether, polyoxyethylene oleyl ether and polyoxyethylene cetyl ether; polyoxyethylene fatty acid diethers; polyoxyethylene fatty acid monoethers; polyoxyethylene-polyoxypropylene block polymer; acetylene alcohol; acetylene glycol derivatives, such as, acetylene glycol, polyethoxyate of acetylene alcohol, and polyethoxyate of acetylene glycol; silicon-containing surfactants, such as, Fluorad ([trademark], manufactured by Sumitomo 3M Limited), MEGAFAC ([trademark], manufactured by DIC Corporation), and Surufuron ([trademark], manufactured by Asahi Glass Co., Ltd.); and organic siloxane surfactants, such as, KP341 ([trademark], manufactured by Shin-Etsu Chemical Co., Ltd.). Examples of the above acetylene glycols include: 3-methyl-1-butyne-3-ol, 3-methyl-1-pentyne-3-ol, 3,6-dimethyl-4-octyne-3,6-diol, 2,4,7,9-tetramethyl- 5-decyne-4,7-diol, 3,5-dimethyl-1-hexyne-3-ol, 2,5-dimethyl-3-hexyne-2,5-diol, and 2,5-dimethyl-2,5- hexanediol.

Examples of the anionic surfactants include: ammonium salts and organic amine salts of alkyl diphenylether disulfonic acids, ammonium salts and organic amine salts of alkyl diphenylether sulfonic acids, ammonium salts and organic amine salts of alkyl benzene sulfonic acids, ammonium salts and organic amine salts of polyoxyethylenealkylether sulfuric acids, and ammonium salts and organic amine salts of alkyl sulfuric acids.

Further, examples of the amphoteric surfactants include 2-alkyl-N-carboxymethyl-N-hydroxyethyl imidazolium betaine, and laurylic acid amidopropyl hydroxy sulfone betaine.

Those surfactants can be used singly or in combination of two or more. The amount thereof is normally 50 to 2000 ppm, preferably 100 to 1000 ppm based on the photosensitive composition of the present invention.

According to necessity, a sensitizer can be incorporated into the photosensitive composition of the present invention. Examples of the sensitizer preferably used in the composition of the present invention include Coumarin, keto coumarin, derivatives thereof, thiopyrylium salts, and acetophenone. Specifically, concrete examples thereof include: sensitizing dyes, such as, p-bis(o-methyl stryl)benzene, 7-dimethylamino-4-methyl quinolone-2,7-amino-4-methyl coumarin, 4,6-dimethyl-7-ethylaminocoumarin, 2-(p-dimethylamino stryl) pyridylmethyl iodide, 7-diethylaminocoumarin, 7-diethylamino-4-methylcoumarin, 2,3,5,6-1H,4H-tetrahydro-8-methylquinolidino-<9,9a,1-gh>coumarin, 7-diethylamino-4-trifluoromethylcoumarin, 7-dimethylamino-4-trifluoromethylcoumarin, 7-amino-4-trifluoromethylcoumarin, 2,3,5,6-1H,4H-tetrahydroquinolidino-<9,9a,1-gh>Coumarin, 7-ethylamino-6-methyl-4-tri fluoromethylcoumarin, 7-ethylamino-4-trifluoromethylcoumarin, 2,3,5,6-1H,4H-tetrahydro-9-carboethoxyquinolidino-<9,9a,1-gh>coumarin, 3-(2'-N-methyl-benzimidazolyl)-7-N,N-diethylaminocoumarin, N-methyl-4-trifluoromethylpiperidino-<3,2-g>Coumarin, 2-(p-dimethylaminostryl)benzo-thiazolylethyl iodide, 3-(2'-benzimidazolyl)-7-N,N-diethyl amino coumarin, 3-(2'-benzothiazolyl)-7-N,N-diethyl amino coumarin, and pyrylium or thiopyrylium salts represented by the following formula. The sensitizing dye makes it possible to carry out patterning by use of inexpensive light sources, such as, a high-pressure mercury lamp (360 to 430 nm). The amount thereof is preferably 0.05 to 15 weight parts, more preferably 0.1 to 10 weight parts based on 100 weight parts of the (meth)acrylic polymer.

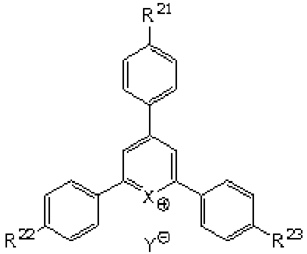

| X | R²¹ | R²² | R²³ | Y |
|---|---|---|---|---|
| S | OC₄H₉ | H | H | BF₄ |
| S | OC₄H₉ | OCH₃ | OCH₃ | BF₄ |
| S | H | OCH₃ | OCH₃ | BF₄ |
| S | N(CH₃)₂ | H | H | ClO₂ |
| O | OC₄H₉ | H | H | SbF₆ |

As the sensitizer, it is also possible to adopt a compound having an anthracene skeleton. Concrete examples thereof include compounds represented by the following formula (C): 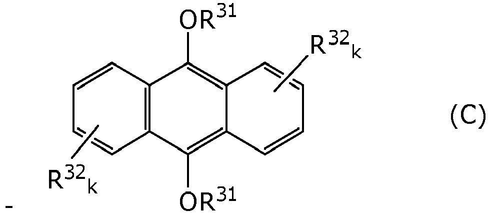 in which
each R³¹ is independently a substituent group selected from the group consisting of alkyl groups, aralkyl groups, aryl groups, hydroxyalkyl groups, alkoxyalkyl groups, glycidyl groups and halogenated alkyl groups;
each R³² is independently a substituent group selected from the group consisting of hydrogen, alkyl groups, alkoxy groups, halogen atoms, nitro groups, sulfonic acid groups, hydroxyl group, amino groups, and carboalkoxy groups; and
each k is independently an integer of 0 and 1 to 4.

The sensitizers having anthracene skeletons are disclosed in, for example, Patent documents 3 and 4. When the sensitizer having an anthracene skeleton is added, the amount thereof is preferably 0.01 to 5 weight parts based on 100 weight parts of the (meth)acrylic polymer.

Further, if necessary, a stabilizer can be also added into the photosensitive composition of the present invention. The stabilizer can be freely selected from those generally known. However, in the present invention, aromatic amines are preferred because they have high effect on stabilization. Among those aromatic amines, preferred are pyridine derivatives and particularly preferred are pyridine derivatives having bulky substituent groups at 2- and 6-positions. Concrete examples thereof are as follows:

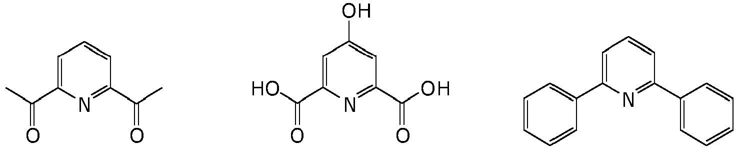

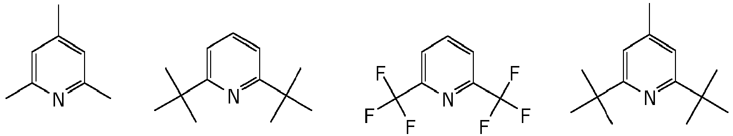

### - Color conversion medium

In another aspect, the invention relates to a color conversion medium comprising a plurality of nanosized fluorescent material, a wetting and dispersing agent, and a polymer matrix, wherein the wetting and dispersing agent comprises an anchoring group which forms a salt of cationic species and anionic species.

The cationic species of the anchoring group can be selected from the group consisting of primary amine, secondary amine, tertiary amine, quaternary ammonium, and a combination of any of these.

In a preferred embodiment of the present invention, the anionic species of the anchoring group is selected from the group consisting of halogen, phosphate, carboxylate, sulfonate, phosphonate and a combination of any of these.

More preferably, the anchoring group of the wetting and dispersing agent is a quaternary ammonium salt represented by following chemical formula (I),

-N⁺R₁R₂R₃ X⁻ (I)

(Wherein the chemical formula (I), R₁ is a hydrogen atom, alkyl group having 1 to 30 carbon atoms, or an aryl group having 1 to 30 carbon atoms; R₂ is a hydrogen atom, alkyl group having 1 to 30 carbon atoms, or an aryl group having 1 to 30 carbon atoms; R₃ is a hydrogen atom, alkyl group having 1 to 30 carbon atoms, or an aryl group having 1 to 30 carbon atoms; R₁, R₂ and R₃ can be same or different of each other, X is an anion selected from the group consisting of F, CI, Br, I, phosphate, carboxylate, sulfonate,and phosphonate.)

Even more preferably, R₁ is a hydrogen atom or an alkyl group having 1 to 30 carbon atoms; R2 is a hydrogen atom or an alkyl group having 1 to 30 carbon atoms; R3 is a hydrogen atom or an alkyl group having 1 to 30 carbon atoms; R₁, R₂ and R₃ can be same or different of each other.

According to the present invention, the weight-average molecular weight of the wetting and dispersing agent is not particularly limited.
Preferably, it is in the range from 2,000 - 100,000, more preferably, it is in the range from 5,000 - 30,000 from the view point of better dispersivity and film strength.

According to the present invention, the molecular weight M_{w} is determined by means of GPC (= gel permeation chromatography) against an internal polystyrene standard.

As the wetting and dispersing agents, commercially available wetting and dispersing agents comprising an anchoring group which forms salt, can be used preferably. Such as BYK-180 ([trademark], from BYK com.), DA-325, DA-7301 (Kusumoto chemicals, Ltd.) as described in -wetting and dispersing agents.

In a preferred embodiment of the present invention, the color conversion medium is a color conversion film, a remote phosphor tape, a part of a LED chip comprising nanosized fluorescent material, a wetting and dispersing agent and a polymer matrix.

Preferably, the color conversion medium is a color conversion film.

According to the present invention, the term "film" includes "layer" and "sheet" like structures.

In some embodiment of the present invention, the color conversion medium (100) further comprises additives selected from the group consisting of scattering particles, reflective index adjusting material and a combination of any of these.

In another aspect, the invention relates to use of the photosensitive composition, in a color conversion medium fabrication process.

In another aspect, the invention also relates to use of the color conversion medium (100) in an optical device.

In another aspect, the invention further relates to an optical device (200) comprising the color conversion medium (100).

In a preferred embodiment of the present invention, the optical device (200) can embrace a light source (230).

According to the present invention, the type of light source in the optical device is not particularly limited. Such as white light source, UV, or blue single color light source, blue and yellow light source, blue and red light source.

For example, light emitting diode (hereafter LED), cold cathode fluorescent lamp (hereafter CCFL), electro luminescent (hereafter EL) lamp, organic light emitting diode (hereafter OLED) or a combination of any of these, can be used as a light source of the present invention.

In a preferred embodiment of the present invention, optionally, the light source (230) can embrace a light guiding plate to increase light uniformity from the light source.

In a preferred embodiment of the present invention, the optical device (200) comprises a light modulator (210).

In a preferred embodiment of the present invention, the light modulator (210) is selected from the group consisting of liquid crystal element, Micro Electro Mechanical Systems (here in after "MEMS"), electro wetting element, and electrophoretic element.

In the case of the light modulator is a liquid crystal element, any type of liquid crystal element can be used in this way. For example, twisted nematic (hereafter TN) mode, vertical alignment mode, in plane switching mode, guest host mode liquid crystal element, which commonly used for liquid crystal displays are preferable.

Furthermore, according to the present invention, normally black TN mode liquid crystal element is also applicable as the light modulator.

In some embodiments of the present invention, optionally, the optical device (200) comprises a light scattering layer including the plural of light scattering particles.

In a preferred embodiment of the present invention, the light scattering layer is placed in between the light source and the color conversion medium (100) to reduce glare state of the device caused by ambient light scattering.

Preferably, the plural of light scattering particles is only in the light scattering layer and / or one or more of other layers that is placed the light source side from the color conversion medium (100).

Without wishing to be bound by theory, it is believed that such embodiment may lead less color shift and / or better the brightness contrast of the element under incident light.

Preferably, the light scattering layer is placed onto the surface of the light source side of the color conversion medium (100).

Preferably, the plural of light scattering particles is in the color conversion medium (100), in case of the light modulator is placed behind the color conversion medium (100) viewed from the light source.

In some embodiments of the present invention, the light modulator is placed on the light extraction side of the color conversion medium (100).

In some embodiments of the present invention, the light modulator (210) is placed in between the light source (230) and the color conversion medium (100).

According to the present invention, in some embodiments, preferably, the optical device (200) further comprises a film having nano-meter scale structures on one side of the film and the other side of the film can be directly attached onto the outmost surface of the light emission side of the color conversion medium (100) to increase outcoupling efficiency of the color conversion medium and the optical device (200).

More preferably, the film having nano-meter scale structures is attached directly onto the color conversion medium (100)

Without wishing to be bound by theory it is believed that nano-meter scale structures can increase the amount of light that leaves the light converting film. These structures can be fabricated by well-known techniques, for example with using nano-inprinting techniques.

In general, the nano-meter scale structures can overlap for the plural sub color pixels. Therefore, the nano-meter scale structures is preferably applicable for small size pixels.

More preferably, the film having nano-meter scale structures is moth-eye lens film like described in "Sang Soon Oh et. al., Microelectronic Engineering, vol. 87, Issue 11, Nov. 2010, pp 2328 - 2331.

According to the present invention, in some embodiments, the surface of the color conversion medium (100), which opposite side from the light source, can have nano-meter scale structures instead of the film having nano-meter scale structures. Without wishing to be bound by theory, it is believed that the nano-meter scale structures may prevent light loss by the total reflection.

In some embodiments of the present invention, optionally, the light source can be switchable.

According to the present invention, the term "switchable" means that the light can selectively be switched on or off.

In a preferred embodiment of the present invention, the switchable light source is selected from the group consisting of, active matrix EL, passive matrix EL, a plural of LEDs, active matrix OLED, passive matrix OLED and a combination of any of these.

In some embodiments of the present invention, optionally, the optical device (200) can further include a color filter layer. According to the present invention, as the color filter, any type of publically known color filter including red, green and blue sub color region for optical devices, such as Liquid Crystal Display color filter, can be used in this way preferably.

Each feature disclosed in this specification, unless stated otherwise, may be replaced by alternative features serving the same, equivalent, or similar purpose. Thus, unless stated otherwise, each feature disclosed is but one example of a generic series of equivalent or similar features.

In another aspect, the invention further relates to use of the photosensitive composition in a color conversion medium fabrication process.

### - Fabrication methods

In another aspect, the present invention furthermore relates to method for preparing the color conversion medium (100), wherein the method comprises following steps (a) and (b) in this sequence;
(a) providing the photosensitive composition onto a substrate
(b) polymerizing the photosensitive composition by heat treatment, or exposing the photosensitive composition under ray of light or a combination of any of these.

In some embodiments of the present invention, the heat temperature of the heat treatment in step (b) can be in the range from 40 °C to 150 °C. In a preferred embodiment of the present invention, the baking temperature in baking step is in the range from 70 °C to 140 °C. More preferably, it is in the range from 80 °C to 120 °C.
The heat treatment time is not particularly restricted, preferably it is from 30 seconds to 24 hours, more preferably from 60 seconds to 3 hours.

### - Coating step

According to the present invention, to provide the photosensitive composition onto a substrate, any type of publically known coating method can be used preferably. For examples, immersion coating, gravure coating, roll coating, bar coating, brush coating, spray coating, doctor coating, flow coating, spin coating, and slit coating.

The substrate to be coated with the photosensitive composition in step (a) is also not particularly limited, and is properly selected from, for example, a silicon substrate, a glass substrate and a polymer film. And the substrate can be solid or flexible.

### - Prebaking step

In a preferred embodiment of the present invention, optionally, after step (a), prebaking (preheating treatment) step can be applied to the photosensitive composition provided onto a substrate for the purposes of drying and of reducing the solvent remaining therein. The prebaking step can be carried out at a temperature of generally 50 to 150°C, preferably 90 to 120°C for 10 to 300 seconds, preferably 30 to 120 seconds on a hotplate or for 1 to 30 minutes in a clean oven.

### - Exposing step as step (b) to polymerlize the photosensitive composition

In a preferable embodiment of the present invention, after the coating is formed, the surface thereof can be exposed to light. As a light source for the exposure, it is possible to adopt any light source used in conventional pattern-formation processes. Examples of the light source include high-pressure mercury lamp, low- pressure mercury lamp, metal halide lamp, xenon lamp, laser diode and LED. Light for the exposure is normally UV rays of g-line, h-line, i-line or the like. Except for in the case of ultrafine fabrication of semiconductors and the like, it is general to use light of 360 to 430 nm (high-pressure mercury lamp) for patterning in several micrometers to several tens of micrometers. Particularly in producing a liquid crystal display, light of 430 nm is often used. As described above, in that case, it is advantageous to combine a sensitizing dye with the negative-working photosensitive composition of the present invention. Energy of the exposure light depends on the light source and the thickness of the coating, but is generally 10 to 2000 mJ/cm², preferably 20 to 1000 mJ/cm² to obtain satisfying resolution and to avoid halation.

In order that the coating can be imagewise exposed to light, common photomasks are employable. Any photomask can be selected from known ones. There are no particular restrictions on the environmental conditions in the exposure, and the exposure can be carried out under an ambient atmosphere (the normal atmosphere) or under a nitrogen atmosphere. If a film is to be formed on the whole surface of the substrate, the whole substrate surface is exposed to light. In the present invention, the term "pattern film" includes a film thus formed on the whole surface of the substrate.

### - Post-exposure baking step

After the exposing step (b), optionally, post-exposure baking can be carried out according to necessity with the aim of promoting interpolymer reactions caused by the reaction initiator in the exposed area of the coating.

The temperature of the post-exposure baking is preferably 40 to 150°C, more preferably 60 to 120°C.

### - Development step

After the exposing step (b), development step (c) can optionally be carried out if it is required. If a film is to be formed on the whole surface of the substrate, development step (c) can be omitted. As a developer used in the development step, it is possible to adopt any developer employed in developing conventional photosensitive compositions. In the present invention, TMAH aqueous solutions are used to determine the dissolution rate of the photosensitive composition but they by no means restrict the developer for forming a cured film. Preferred examples of the developer include alkali developers which are aqueous solutions of alkaline compounds, such as, tetraalkylammonium hydroxide, choline, alkali metal hydroxides, alkali metal (meta)silicates (hydrate), alkali metal (meta)phosphates (hydrate), ammonia, alkylamines, alkanolamines, and heterocyclic amines. Particularly preferred is an aqueous solution of tetraalkylammonium hydroxide. Those alkali developers may contain water-soluble organic solvents, such as, methanol and ethanol, or surfactants, if necessary. The developing method can be freely selected from known methods, such as, dip, paddle, shower, slit, cap coat and spray development processes. As a result of the development, a pattern can be obtained. After developed with a developer, the pattern is preferably washed with water. Or acetone washing process after development step can be optionally added.

Preferably, the method further comprises step (d) before step (a),
(d) ligand exchange of the nanosized fluorescent material with the wetting and dispersing agent

With using the ligand exchange process, the wetting and dispersing agent can be introduced onto the surface of the nanosized fluorescent material. Such ligand exchange process described in for example, Thomas Nann, Chem. Commun., 2005, 1735 - 1736, DOI: 10.1039/b-414807j can be used preferably.

In some embodiments of the present invention, an ultra-centrifuge process after the ligand exchange process of the nanosized fluorescent material can be applied to remove the excess amount of wetting and dispersing agent before mixing the ligand exchanged nanosized fluorescent material with (meth)acrylic polymer mixture, if desired.

In another aspect, the present invention furthermore relates to method for preparing the optical device (200), wherein the method comprises following step (A);
(A) providing the color conversion medium (100) in an optical device.

### The effect of the invention

1. The present inveniton provides a novelphotosensitive compostion comprising a plurality of nanosized fluorescent materials, and a (meth)acrylic polymer, which may lead better dispersivity of nanosized fluorescent materials in a color convesion medium, preferably in a color conversion film, with higher concentration of the nanosized fluorescent materials.
2. A novel photosensitive compostion comprising a nanosized fluorescent materials, and a (meth)acrylic polymer, which can realize improved dispersivity of nanosized fluorescent materials in a composition with higher concentration of the nanosized fluorescent materials.
3. A novel photosensitive composition comprising a plurality of nanosized fluorescent materials, and a (meth)acrylic polymer, which can form thiner film with good uniformity and good dispersivity of a plurality of nanosized fluorescent materials in the film when it is used for film fabrication process.
4. A novel photosensitive compostion comprising a plurality of nanosized fluorescent materials, and a (meth)acrylic polymer which well fits to lower temprerature method for preparation of color conversion medium to save energy in the preparaton and / or to prevent quenching of the plurality of nanosized fluorescent materials in the preparation of color conversion medium.

### Definition of Terms

The term "fluorescent" is defined as the physical process of light emission by a substance that has absorbed light or other electromagnetic radiation. It is a form of luminescence. In most cases, the emitted light has a longer wavelength, and therefore lower energy, than the absorbed radiation.

The term "semiconductor" means a material which has electrical conductivity to a degree between that of a conductor (such as copper) and that of an insulator (such as glass) at room temperature.

The term "inorganic" means any material not containing carbon atoms or any compound that containing carbon atoms ionically bound to other atoms such as carbon monoxide, carbon dioxide, carbonates, cyanides, cyanates, carbides, and thiocyanates.

The term "emission" means the emission of electromagnetic waves by electron transitions in atoms and molecules.

The term "photosensitive" means that the respective composition chemically reacts in response to suitable light irradiation. The light is usually chosen from visible or UV light. The photosensitive response includes hardening or softening of the composition, preferably hardening. Preferably the photosensitive composition is a photo-polymerizable composition.

The working examples 1 - 2 below provide descriptions of the present invention, as well as an in detail description of their fabrication, but it does not limit the scope of the invention.

### Working Examples

### Working Example 1: Fabrication of photosensitive composition with a dispersing agent and color conversion medium

### - Ligand exchange process

30 mg of hydrophobic green emission type dot-shaped nanocrystals and 21 mg of wetting and dispersing agent BYK-180 ([trademark], from BYKco.) were dispersed in 3 ml of chloroform and stirred at 60 degrees C under nitrogen atmosphere overnight.

Then, 0.1 g of PGMEA (propylene glycol monomethyl ether acetate) was added into the obtained solution.
After adding PGMEA, chloroform in the solution was evaporated under reduced pressure at 40 °C.
After the evaporation process of the chloroform, PGMEA was again added into the solution to adjust total weight of the obtained solution to 171 mg. Finally, the solution containing the wetting and dispersing agent covered green emission type dot-shaped nanocrystals and PGMEA solvent was obtained.

### - Fabrication process of the photosensitive compositions of the invention

Polymer mixture L1 (from Merck KGaA) comprising an acryl polymer mixture soluble in TMAH aqueous solution, wherein the polymer mixture L1 comprises acryl polymer mixture including an acrylic unit including an acid group and a silane modified acrylic unit, a photo - radical generator Irgacure OXE02 and Irgacure 369 ([Trade mark] from BASF SE, each 6 wt. % based on the weight of the acrylic polymer mixture), Acryl monomer A-DOD, and A-DCP (from Shin-Nakamura Chemical, each 20 wt. % based on the weight of the acrylic polymer mixture), and 70 wt. % of PGMEA solvent based on the weight of the acrylic polymer, and the resulting solution of the wetting and dispersing agent covered green emission type rod-shaped nanocrystals with PGMEA were mixed at room temperature.

Finally, the green-type photosensitive composition (29 wt. % of green-shaped nanocrystals based on the weight of the total solid components of polymer mixture L1) was fabricated.

### - Fabrication process of the color conversion films of the present invention

A glass substrate was cleaned by sonicating in acetone.

Then the first red type photosensitive composition was coated onto the cleaned glass substrate with using bar coating technique. The resulting substrate was heated at 100 °C for 90 seconds at air condition to evaporate the solvent.

Finally, the green color conversion film No. 1 fabricated onto the substrate was obtained.

### Comparative Example 1: Fabrication of photosensitive composition with a dispersing agent and color conversion medium

Photosensitive composition and color conversion film No.2 were fabricated in the same manner described in working example 1 except for a wetting and dispersing agent having an anchor group of acid (BYK-170) was used instead of BYK-180.

### Working Example 2: Fluorescence observation

Microscope OLYMPUS BX-51 equipped with fluorescent mirror unit U-MWIB3 consisting of a excitation filter (passing the excitation light in between 460 nm - 495 nm) and absorption filter / Dichroic Mirror passing 510 nm or more longer light wavelength, was used for microscopic observation of the color conversion films fabricated in working example 1 and comparative example 1.
In a fluorescence observation mode, excitation light from the 100 W Hg lamp was filtered by the excitation filter of the fluorescent mirror unit U-MWIB3, then, the filtered excitation light went into the color conversion films.

The converted light and the excitation light from the light source and passed through the color conversion film was then filtered by the absorption filter / Dichroic Mirror.
Magnification ratio during the fluorescence observation was x4.

Homogeneously green image was obtained in the observed area of the color conversion film No.1. On the other side, about color conversion film No.2, a lot of small aggregations of quantum dots were observed.

## Claims

1. A photosensitive composition comprising a plurality of nanosized fluorescent materials, a (meth)acrylic polymer, and a wetting and dispersing agent, wherein the wetting and dispersing agent comprises an anchoring group which forms a salt of cationic species and anionic species, wherein the cationic species of the anchoring group is selected from the group consisting of primary ammonium, secondary ammonium, tertiary ammonium, quaternary ammonium, and a combination of any of these, wherein the (meth)acrylic polymer further comprises a silane modified (meth)acrylic unit, and
said photosensitive composition does not include polysiloxane.

2. The photosensitive compositon according to claim 1, wherein the anionic species of the anchoring group is selected from the group consisting of halogen, phosphate, carboxylate, sulfonate, phosphonate and a combination of any of these.

3. The photosensitive composition according to claim 1 or 2, wherein the anchoring group is a quaternary ammonium salt represented by following chemical formula (I),
-N⁺R₁R₂R₃ X⁻ (I)
(Wherein the chemical formula (I), R₁ is a hydrogen atom, alkyl group having 1 to 30 carbon atoms, or an aryl group having 1 to 30 carbon atoms; R₂ is a hydrogen atom, alkyl group having 1 to 30 carbon atoms, or an aryl group having 1 to 30 carbon atoms; R₃ is a hydrogen atom, alkyl group having 1 to 30 carbon atoms, or an aryl group having 1 to 30 carbon atoms; R₁, R₂ and R₃ can be same or different of each other, X is an anion selected from the group consisting of F, CI, Br, I, phosphate, carboxylate, sulfonate,and phosphonate.)

4. The photosensitive compositon according to any one of claims 1 to 3, wherein the polymer is a (meth)acrylic polymer.

5. The photosensitive composition according to any one of claims 1 to 4, wherein the (meth)acrylic polymer comprises a (meth)acrylic unit including an acid group.

6. The photosensitive compositon according to any one of claims 1 to 5, wherein the photosensitive compositon comprises a polymerization initiator.

7. The photosensitive compositon according to any one of claims 1 to 6, wherein the photosensitive composition further comprises a solvent.

8. The photosensitive composition according to any one of claims 1 to 7, wherein the photosensitive composition further comprises a chemical compound including two or more of (meth)acryloyl groups.

9. A color conversion medium (100) comprising a plurality of nanosized fluorescent materials (110), a (meth)acrylic polymer (120), and a wetting and dispersing agent, wherein the wetting and dispersing agent comprises an anchoring group which forms a salt of cationic species and anionic species, wherein the cationic species of the anchoring group is selected from the group consisting of primary ammonium, secondary ammonium, tertiary ammonium, quaternary ammonium, and a combination of any of these, wherein the (meth)acrylic polymer further comprises a silane modified (meth)acrylic unit, and
said photosensitive composition does not include polysiloxane.

10. Use of the photosensitive composition according to any one of claims 1 to 8 in a color conversion medium fabrication process.

11. An optical device (200) comprising the color conversion medium (100) according to claim 9.

12. Method for preparing a color conversion medium, wherein the method comprises following steps (a) and (b) in this sequence;
(a) providing the photosensitive composition according to any one of claims 1 to 8 onto a substrate, and
(b) polymerizing the photosensitive composition by heat treatment, or exposing the photosensitive composition under ray of light or a combination of any of these.

13. Method for preparing an optical device (200), wherein the method comprises following step (A);
(A) providing the color conversion medium (100) according to claim 9, in an optical device.

## Patentansprüche

1. Lichtempfindliche Zusammensetzung enthaltend eine Vielzahl von nanogroßen Fluoreszenzmaterialien, ein (Meth-)Acrylpolymer und ein Netz- und Dispergiermittel, wobei das Netz- und Dispergiermittel eine Ankergruppe enthält, die ein Salz von kationischen Spezies und anionischen Spezies bildet, wobei die kationische Spezies der Ankergruppe ausgewählt ist aus der Gruppe bestehend aus primärem Ammonium, sekundärem Ammonium, tertiärem Ammonium, quaternärem Ammonium und einer Kombination von beliebigen davon, wobei das (Meth-)-Acrylpolymer ferner eine silanmodifizierte (Meth-)Acryleinheit enthält, und
die lichtempfindliche Zusammensetzung kein Polysiloxan enthält.

2. Lichtempfindliche Zusammensetzung nach Anspruch 1, wobei die anionische Spezies der Ankergruppe ausgewählt ist aus der Gruppe bestehend aus Halogen, Phosphat, Carboxylat, Sulfonat, Phosphonat und einer Kombination aus beliebigen davon.

3. Lichtempfindliche Zusammensetzung nach Anspruch 1 oder 2, wobei die Ankergruppe ein quaternäres Ammoniumsalz ist, das dargestellt wird durch die folgende chemische Formel (I)
-N⁺R₁R₂R₃ X⁻ (I)
(wobei in der chemischen Formel (I) R₁ ein Wasserstoffatom, eine Alkylgruppe mit 1 bis 30 Kohlenstoffatomen oder eine Arylgruppe mit 1 bis 30 Kohlenstoffatomen ist; R₂ ein Wasserstoffatom, eine Alkylgruppe mit 1 bis 30 Kohlenstoffatomen oder eine Arylgruppe mit 1 bis 30 Kohlenstoffatomen ist; R₃ ein Wasserstoffatom, eine Alkylgruppe mit 1 bis 30 Kohlenstoffatomen oder eine Arylgruppe mit 1 bis 30 Kohlenstoffatomen ist; R₁, R₂ und R₃ gleich oder voneinander verschieden sein können, X ein aus der Gruppe bestehend aus F, Cl, Br, I, Phosphat, Carboxylat, Sulfonat und Phosphonat ausgewähltes Anion ist).

4. Lichtempfindliche Zusammensetzung nach irgendeinem der Ansprüche 1 bis 3, wobei es sich bei dem Polymer um ein (Meth-)Acrylpolymer handelt.

5. Lichtempfindliche Zusammensetzung nach irgendeinem der Ansprüche 1 bis 4, wobei das (Meth-)Acrylpolymer eine (Meth-)Acryleinheit mit einer Säuregruppe enthält.

6. Lichtempfindliche Zusammensetzung nach irgendeinem der Ansprüche 1 bis 5, wobei die lichtempfindliche Zusammensetzung einen Polymerisationsinitiator enthält.

7. Lichtempfindliche Zusammensetzung nach irgendeinem der Ansprüche 1 bis 6, wobei die lichtempfindliche Zusammensetzung ferner ein Lösungsmittel enthält.

8. Lichtempfindliche Zusammensetzung nach irgendeinem der Ansprüche 1 bis 7, wobei die lichtempfindliche Zusammensetzung ferner eine chemische Verbindung mit zwei oder mehr von (Meth-)Acryloylgruppen enthält.

9. Farbkonvertierungsmedium (100) enthaltend eine Vielzahl von nanogroßen Fluoreszenzmaterialien (110), ein (Meth-)Acrylpolymer (120) und ein Netz- und Dispergiermittel, wobei das Netz- und Dispergiermittel eine Ankergruppe enthält, die ein Salz von kationischen Spezies und anionischen Spezies bildet, wobei die kationische Spezies der Ankergruppe ausgewählt ist aus der Gruppe bestehend aus primärem Ammonium, sekundärem Ammonium, tertiärem Ammonium, quaternärem Ammonium und einer Kombination von beliebigen davon, wobei das (Meth-)Acrylpolymer ferner eine silanmodifizierte (Meth-)Acryleinheit enthält, und
die lichtempfindliche Zusammensetzung kein Polysiloxan enthält.

10. Verwendung der lichtempfindlichen Zusammensetzung nach irgendeinem der Ansprüche 1 bis 8 in einem Herstellungsverfahren für ein Farbkonvertierungsmedium.

11. Optische Vorrichtung (200) enthaltend das Farbkonvertierungsmedium (100) nach Anspruch 9.

12. Verfahren zur Herstellung eines Farbkonvertierungsmediums, wobei das Verfahren die folgenden Schritte (a) und (b) in dieser Reihenfolge umfasst:
(a) Bereitstellen der lichtempfindlichen Zusammensetzung nach irgendeinem der Ansprüche 1 bis 8 auf einem Substrat und
(b) Polymerisieren der lichtempfindlichen Zusammensetzung durch Wärmebehandlung oder Belichten der lichtempfindlichen Zusammensetzung mit Lichtstrahlen oder eine Kombination von beliebigen davon.

13. Verfahren zur Herstellung einer optischen Vorrichtung (200), bei dem das Verfahren den folgenden Schritt (A) umfasst:
(A) Bereitstellen des Farbkonvertierungsmediums (100) nach Anspruch 9 in einer optischen Vorrichtung.

## Revendications

1. Composition photosensible comprenant une pluralité de matériaux fluorescents de dimension nanométrique, un polymère (méth)acrylique, et un agent mouillant et dispersant, dans laquelle l'agent mouillant et dispersant comprend un groupe d'ancrage qui forme un sel d'espèces cationiques et d'espèces anioniques, dans laquelle les espèces cationiques du groupe d'ancrage sont sélectionnées parmi le groupe qui est constitué par l'ammonium primaire, l'ammonium secondaire, l'ammonium tertiaire, l'ammonium quaternaire, et une combinaison de quelconques de ceux-ci, dans laquelle le polymère (méth)acrylique comprend en outre une unité (méth)acrylique modifiée par silane, et
ladite composition photosensible n'inclut pas de polysiloxane.

2. Composition photosensible selon la revendication 1, dans laquelle les espèces anioniques du groupe d'ancrage sont sélectionnées parmi le groupe qui est constitué par halogène, phosphate, carboxylate, sulfonate, phosphonate et une combinaison de quelconques de ceux-ci.

3. Composition photosensible selon la revendication 1 ou 2, dans laquelle le groupe d'ancrage est un sel d'ammonium quaternaire qui est représenté par la formule chimique qui suit (I),
-N⁺R₁R₂R₃ X⁻ (I)
(dans la formule chimique (I), R₁ est un atome d'hydrogène, un groupe alkyle qui comporte de 1 à 30 atome(s) de carbone, ou un groupe aryle qui comporte de 1 à 30 atome(s) de carbone ; R₂ est un atome d'hydrogène, un groupe alkyle qui comporte de 1 à 30 atome(s) de carbone, ou un groupe aryle qui comporte de 1 à 30 atome(s) de carbone ; R₃ est un atome d'hydrogène, un groupe alkyle qui comporte de 1 à 30 atome(s) de carbone, ou un groupe aryle qui comporte de 1 à 30 atome(s) de carbone ; R₁, R₂ et R₃ peuvent être les mêmes ou peuvent être différents les uns des autres, X est un anion qui est sélectionné parmi le groupe qui est constitué par F, Cl, Br, I, phosphate, carboxylate, sulfonate et phosphonate.)

4. Composition photosensible selon l'une quelconque des revendications 1 à 3, dans laquelle le polymère est un polymère (méth)acrylique.

5. Composition photosensible selon l'une quelconque des revendications 1 à 4, dans laquelle le polymère (méth)acrylique comprend une unité (méth)acrylique qui inclut un groupe acide.

6. Composition photosensible selon l'une quelconque des revendications 1 à 5, dans laquelle la composition photosensible comprend un initiateur de polymérisation.

7. Composition photosensible selon l'une quelconque des revendications 1 à 6, dans laquelle la composition photosensible comprend en outre un solvant.

8. Composition photosensible selon l'une quelconque des revendications 1 à 7, dans laquelle la composition photosensible comprend en outre un composé chimique qui inclut deux groupes (méth)acryloyle ou plus.

9. Milieu de conversion de couleur (100) comprenant une pluralité de matériaux fluorescents de dimension nanométrique (110), un polymère (méth)acrylique (120), et un agent mouillant et dispersant, dans lequel l'agent mouillant et dispersant comprend un groupe d'ancrage qui forme un sel d'espèces cationiques et d'espèces anioniques, dans lequel les espèces cationiques du groupe d'ancrage sont sélectionnées parmi le groupe qui est constitué par l'ammonium primaire, l'ammonium secondaire, l'ammonium tertiaire, l'ammonium quaternaire, et une combinaison de quelconques de ceux-ci, dans lequel le polymère (méth)acrylique comprend en outre une unité (méth)acrylique modifiée par silane, et
ladite composition photosensible n'inclut pas de polysiloxane.

10. Utilisation de la composition photosensible selon l'une quelconque des revendications 1 à 8 au niveau d'un processus de fabrication de milieu de conversion de couleur.

11. Dispositif optique (200) comprenant le milieu de conversion de couleur (100) selon la revendication 9.

12. Procédé pour préparer un milieu de conversion de couleur, dans lequel le procédé comprend les étapes qui suivent (a) et (b) selon cette séquence :
(a) l'application de la composition photosensible selon l'une quelconque des revendications 1 à 8 sur un substrat, et
(b) la polymérisation de la composition photosensible par traitement thermique, ou l'exposition de la composition photosensible à un rayon de lumière ou une combinaison de ces moyens.

13. Procédé pour préparer un dispositif optique (200), dans lequel le procédé comprend l'étape qui suit (A) :
(A) l'application du milieu de conversion de couleur (100) selon la revendication 9, dans un dispositif optique.
